(19) Europäisches Patentamt
European Patent Office
Office européen des brevets

(11) **EP 1 611 778 B1**

(12) **EUROPÄISCHE PATENTSCHRIFT**

(45) Veröffentlichungstag und Bekanntmachung des Hinweises auf die Patenterteilung:
**07.02.2007 Patentblatt 2007/06**

(21) Anmeldenummer: **05716140.8**

(22) Anmeldetag: **17.03.2005**

(51) Int Cl.:
*H05K 7/20* (2006.01)    *H01L 23/44* (2006.01)

(86) Internationale Anmeldenummer:
**PCT/EP2005/002832**

(87) Internationale Veröffentlichungsnummer:
**WO 2005/094150 (06.10.2005 Gazette 2005/40)**

(54) **VERFAHREN UND ANORDNUNG ZUR KÜHLUNG EINES SUBSTRATS, INSBESONDERE EINES HALBLEITERS**

METHOD AND ARRANGEMENT FOR COOLING A SUBSTRATE, ESPECIALLY A SEMICONDUCTOR

PROCEDE ET SYSTEME POUR REFROIDIR UN SUBSTRAT, NOTAMMENT UN SEMI-CONDUCTEUR

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **26.03.2004 DE 102004016400**

(43) Veröffentlichungstag der Anmeldung:
**04.01.2006 Patentblatt 2006/01**

(73) Patentinhaber: **ebm-papst St. Georgen GmbH & Co. KG**
**78112 St. Georgen (DE)**

(72) Erfinder:
• **ANGELIS, Walter, Georg**
**78112 St. Georgen (DE)**

• **LAUFER, Wolfgang**
**78733 Aichhalden (DE)**
• **SEIDLER, Siegfried**
**78056 Villingen-Schwenningen (DE)**

(74) Vertreter: **Raible, Tobias**
**Raible & Raible**
**Schoderstrasse 10**
**70192 Stuttgart (DE)**

(56) Entgegenhaltungen:
**WO-A-91/15722          DE-A1- 3 206 059**
**DE-A1- 4 330 925          DE-C1- 4 330 923**
**US-A1- 2002 075 652**

## Beschreibung

Die Erfindung betrifft ein Verfahren und eine Anordnung zur Kühlung eines Substrats. Als zu kühlendes Substrat dient bevorzugt ein Halbleiter, z. B. ein Mikroprozessor, ein Mikrocomputer oder dergleichen.

Aus der US 6 549 408 B2 kennt man eine Kühlanordnung für eine CPU. Auf dieser ist ein Verdampfer angeordnet, und Kühlmittel in diesem Verdampfer wird durch die Wärme der CPU verdampft und strömt dadurch in einer Steigleitung nach oben zu einem Kondensator, der auf einem höheren geodätischen Niveau angeordnet ist. Dort wird der Dampf gekühlt und verflüssigt und strömt unter der Wirkung der Schwerkraft durch ein Fallrohr zurück zum Verdampfer, wo er erneut verdampft wird.

Der Vorteil einer solchen Anordnung ist, dass sie ruhig läuft; nachteilig ist aber, dass es nach dem 2. Hauptsatz der Thermodynamik hier unmöglich ist, eine Kühlmitteltemperatur unter der Umgebungstemperatur zu erreichen, weil Wärme nur von einem Medium höherer Temperatur zu einem Medium niedrigerer Temperatur strömt. Man erhält vielmehr eine Temperatur des Kühlmittels, die - wegen des notwendigen Temperaturgradienten zur Wärmeübertragung - mindestens 7 bis 10 K über der Umgebungstemperatur liegt, was die Wärmeabfuhr aus der CPU begrenzt, besonders an heißen Tagen. Außerdem ist der Gesamtwirkungsgrad eines solchen Systems nicht gut [K = Kelvin].

Es ist deshalb eine Aufgabe der Erfindung, ein neues Verfahren und eine neue Anordnung zur Kühlung eines Substrats bereitzustellen.

Nach der Erfindung wird diese Aufgabe gelöst durch das Verfahren gemäß Anspruch 1. Man erreicht hierdurch, dass das Kältemittel an der Wärmeübergangsfläche des Verdampfers im Wesentlichen in Form einer siedenden Flüssigkeit vorliegt, die von Nassdampf überlagert ist, so dass sich ein ausgezeichneter Wärmeübergang ergibt, der noch besser ist als bei einer Flüssigkeitskühlung, wobei durch die hier mögliche höhere mittlere logarithmische Temperaturdifferenz der Wärmeübertragung auch tiefere Temperaturen des Substrats erreicht werden können. In dem Kältemittel im Verdampfer treten keine wesentlichen Temperaturdifferenzen auf, d. h. bei der Wärmeübertragung vom Substrat auf das Kältemittel findet nur eine geringe Überhitzung des Kältemittels statt, weil fast ausschließlich latente Wärme (durch Phasenumwandlung) übertragen wird. Damit ist eine weitgehend gleichmäßige und niedrige Verdampfertemperatur gewährleistet, und damit auch eine entsprechend gleichmäßige und niedrige Temperatur des zu kühlenden Substrats. Dies ermöglicht eine hohe Kühlleistung auf kleinem Raum.

Eine andere Lösung der gestellten Aufgabe ergibt sich durch eine Kühlanordnung gemäß Patentanspruch 5. Eine solche Kühlanordnung kann sehr kompakt und effizient ausgelegt werden und eignet sich deshalb z. B. sehr gut für Server und ähnliche Applikationen.

Weitere Einzelheiten und vorteilhafte Weiterbildungen der Erfindung ergeben sich aus dem im Folgenden beschriebenen und in der Zeichnung dargestellten, in keiner Weise als Einschränkung der Erfindung zu verstehenden Ausführungsbeispiel, sowie aus den Unteransprüchen. Es zeigt:

Fig. 1    eine Darstellung eines Ausführungsbeispiels einer erfindungsgemäßen Kälteanordnung, gesehen längs der Linie I-I der Fig. 2,

Fig. 2    eine andere Darstellung der Anordnung nach Fig. 1,

Fig. 3    eine schematische Darstellung des Kältekreislaufs bei der Anordnung nach Fig. 1 und 2,

Fig. 4    eine Darstellung des Kreisprozesses unter Verwendung von Kältemittel im lg-p/h-Diagramm, wobei ein erheblich verbesserter Wärmestrom vom Substrat zum Kältemittel möglich ist,

Fig. 5    ein Diagramm, welches den Verlauf der Temperatur im Verlauf des Kreisprozesses zeigt, und

Fig. 6    einen Schnitt durch eine bevorzugte Ausführungsform eines Hochleistungsverdampfers, der lageunabhängig betrieben werden kann.

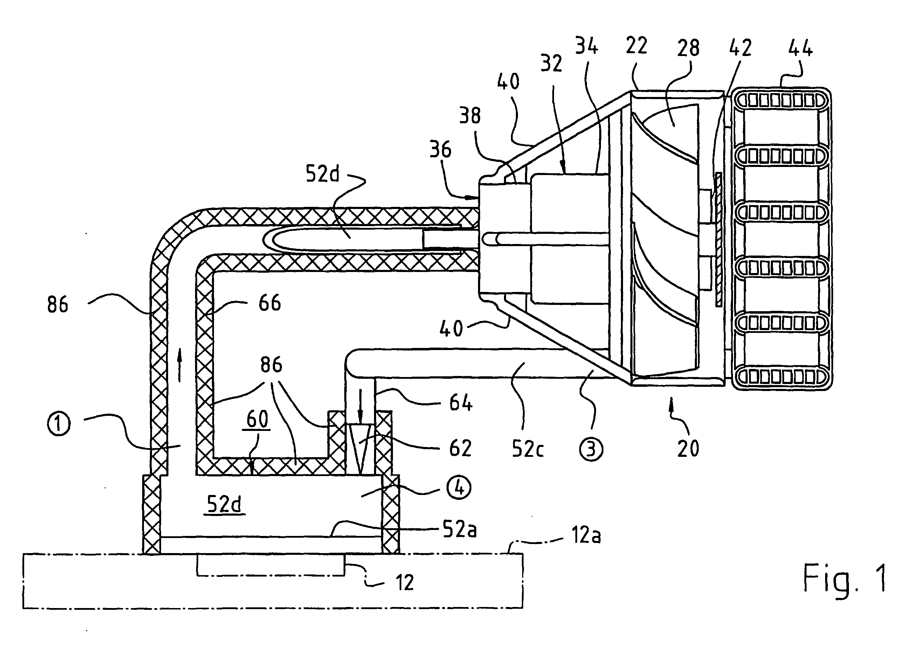

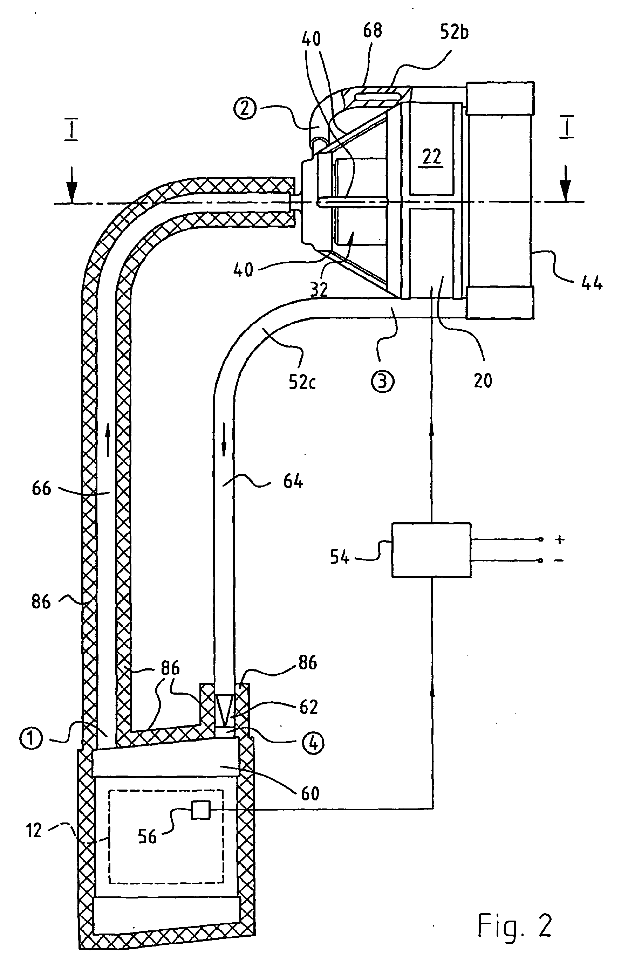

**Fig. 1** zeigt schematisch einen Schnitt durch eine bevorzugte Ausführungsform einer Kühlvorrichtung nach der Erfindung. Ein zu kühlendes Bauteil 12 ist in Fig. 1 und 2 schematisch angedeutet, z.B. ein Mikroprozessor, dessen im Betrieb entstehende Wärme bei einer niedrigen, gleichmäßigen Temperatur abgeführt werden soll, um ein zuverlässiges Arbeiten und eine hohe Lebensdauer bei hoher Wärmeabgabe in kompakter Bauweise zu ermöglichen. Das Bauteil 12 ist gewöhnlich in einem Träger 12a angeordnet, der zum elektrischen Anschluss dient.

Ein Lüfter 20 hat ein Lüftergehäuse 22, einen an diesem über eine Mehrzahl von Speichen 24 befestigten Stator 26, und einen Rotor 28 mit Lüfterflügeln.

Ein Kältemittelkompressor 32 hat eine mit dem Rotor 28 des Lüfters 20 verbundene Magnetglocke 34, ferner ein Kompressorgehäuse 36 und einen schematisch angedeuteten Verdichterrotor 38, sowie einen Antriebsmotor 42, bevorzugt einen kollektorlosen Motor mit regelbarer Drehzahl.

Das Kompressorgehäuse 36 ist über eine Haltespinne 40 mit dem Lüftergehäuse 22 zu einer Baugruppe verbunden. Alternativ kann der Kompressor 32 auf der gegenüberliegenden Seite des Lüfters 20, also dessen Flanschseite, angeordnet werden.

Ein Kondensator 44 ist auf der dem Kompressor 32 gegenüber liegenden Seite mit der von Lüfter 20 und Kompressor 32 gebildeten Baugruppe verbunden, so dass die vom Lüfter 20 geförderte Luft durch den Kondensator 28 hindurch strömt und diesen kühlt. Alternativ könnte der Kondensator 44 auch auf der Seite des Kompressors 32 angeordnet sein.

Der Kompressor 32 wird über die Magnetglocke 34 (magnetische Kupplung) vom Rotor 28 des Lüfters 20 angetrieben. (Alternativ kann der Lüfterrotor 28 über eine magnetische Kupplung vom Rotor eines Antriebsmotors für den Kompressor 32 angetrieben werden.) Die Magnetglocke 34 ist mit dem Rotor 28 fest verbunden. Das Kompressorgehäuse 36 wird von der Haltespinne 40 gehalten, so dass es sich nicht mit der Magnetglocke 34 drehen kann. Der Verdichterrotor 38 ist im Gehäuse 36 drehbar gelagert. Ebenso ist die Magnetglocke 34 durch das Verdichtergehäuse 36 gelagert.

Bei einer Drehung der Magnetglocke 34 durch den Motor 42 des Lüfters 20 wird somit der Verdichterrotor 38 mit bewegt und bewirkt eine Verdichtung des Kältemittels 52.

Bevorzugt hat die Kühlvorrichtung einen Drehzahlregler 54 (Fig. 2) zur Regelung der Drehzahl des Lüfters 20 und/oder des Verdichters 32. Die Solldrehzahl für den Drehzahlregler wird bevorzugt in Abhängigkeit von einem Temperaturwert bestimmt, welcher mittels eines Temperatursensors 56 ermittelt wird, der z.B. am Bauteil 12 angeordnet sein kann.

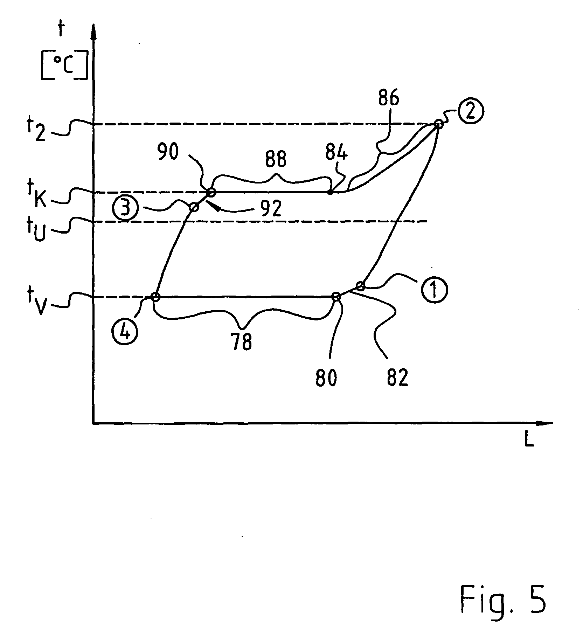

Der Kompressor 32 saugt über eine Leitung 66 gesättigten Kältemitteldampf 52d bzw. geringfügig überhitzten Dampf aus einem Verdampfer 60 ab. Dadurch wird dem Kältemittel 52 im Verdampfer 60 die notwendige Verdampfungsenthalpie $q_0$ entzogen, vgl. **Fig. 4**. Eine weitere Zufuhr von Verdampfungsenthalpie $q_0$ erfolgt durch die Wärmeabgabe des zu kühlenden Substrats 12, z.B. eines zu kühlenden Mikroprozessors. Der Verdampfer 60 ist bevorzugt etwas größer als das Substrat 12.

Es ist darauf hinzuweisen, dass die Verdampfer 60, 60' in Fig. 1 und 2 nur in einer sehr stark schematisierten Form dargestellt sind, wie sie zum Verständnis der Erfindung dienlich ist.

Fig. 1 zeigt, wie im Verdampfer 60 in der Praxis eine Schichtung auftritt, d.h. an seinem Boden und direkt über dem zu kühlenden Bauteil 12 liegt mindestens bereichsweise siedendes Kältemittel 52a, also eine Flüssigkeit (ähnlich wie siedendes Wasser in einem Kochtopf), und darüber liegt Nassdampf 52d, vergleichbar dem Nassdampf in und über siedendem Wasser. Stellenweise kann gelegentlich auch überhitzter Dampf vorliegen, z. B. bei einer sehr starken lokalen Wärmeentwicklung im Substrat 12.

Da das Kältemittel an der Wärmeübertragungsfläche des Verdampfers 60 hauptsächlich als siedende Flüssigkeit 52a vorliegt, die überall den gleichen Druck $p_V$ und damit (da im Nassdampfbereich) auch die gleiche Temperatur $t_V$ hat, ist auch der Wärmedurchgangskoeffizient k sehr gut und im Wesentlichen über der gesamten Wärmeübertragungsfläche gleich. Da auch die Temperatur $t_V$ (und der Verdampferdruck $p_V$) im Verdampfer 60 niedrig gewählt werden kann, z. B. -10 °C, erhält man eine sehr gute Kühlung des Substrats 12. Dabei kann $t_V$ bevorzugt auf einen vorgegebenen Wert, z. B. auf -10 °C, geregelt werden, um z.B. bei einem Prozessor 12 ständig eine hohe Taktfrequenz zu ermöglichen.

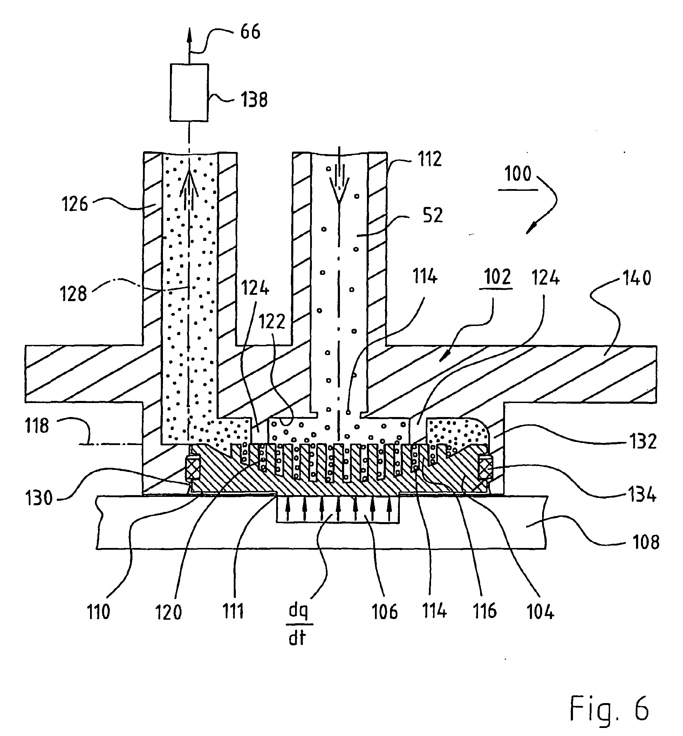

Die Kühlung des Substrats 12 kann noch verbessert werden, indem man den Verdampfer 60 entsprechend auslegt, z. B. dadurch, dass man in seinem Inneren Kühlrippen oder dergleichen vorsieht, welche die Wärmeübergangsfläche und/oder die Turbulenzen vergrößern, vgl. hierzu nachfolgend Fig. 6.

Da das Substrat 12 gewöhnlich in seiner Mitte die höchste Temperatur hat, kann es sehr vorteilhaft sein, das Kältemittel in der Mitte des Verdampfers 60 zuzuführen und am Rand des Verdampfers 60 zum Verdichter 32 abzusaugen. Diese Besonderheiten sind in Fig. 6 dargestellt. Es ist hier darauf hinzuweisen, dass es eine Reihe von vorteilhaften Bauformen für solche Verdampfer gibt, die im Rahmen der Erfindung mit Vorteil eingesetzt werden können, um eine besonders kompakte Bauweise und eine hocheffiziente Kühlung zu erreichen.

Bei der Kühlung entsteht ein Temperaturgradient zwischen dem Substrat 12, dem Verdampfer 60, und dem Kältemittel 52a, 52d im Verdampfer 60. Um eine sehr hohe Wärmestromdichte dQ/dt bei sehr kleinen Wärmeübertragungsflächen zu erreichen, wird der Temperaturgradient in der Weise erhöht, dass die Temperatur in der Wärmesenke, also hier die Temperatur des Kältemittels 52a, 52d im Verdampfer 60, so weit wie nötig reduziert wird, da die maximale Mikroprozessortemperatur ja nach Typ begrenzt ist, so dass eine Erhöhung des Temperaturgradienten durch Erhöhung der Temperatur des Mikroprozessors gewöhnlich keine praktikable Alternative darstellt.

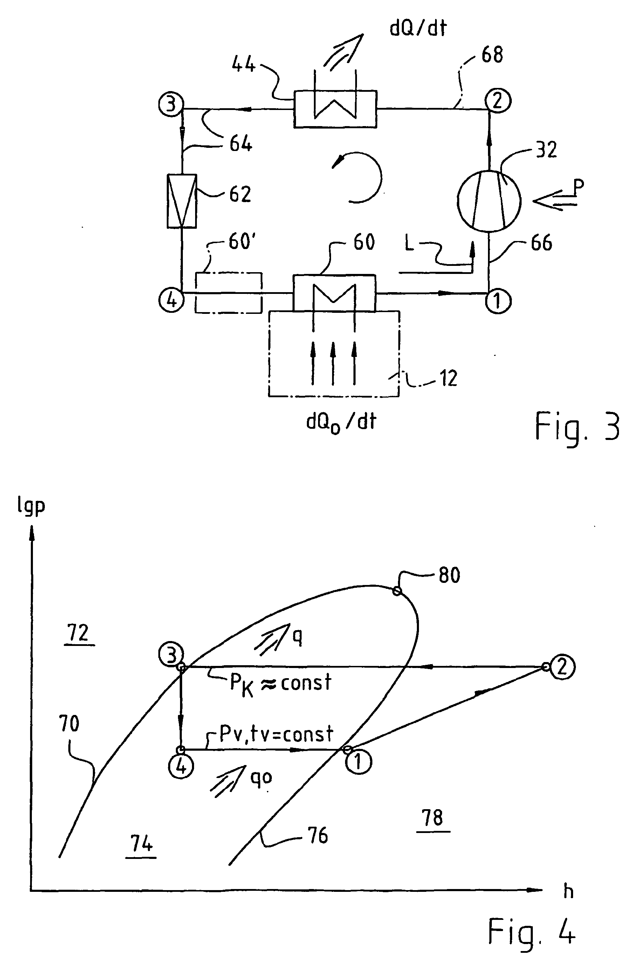

Die Verwendung eines Kältekreislaufs, wie er in den Fig. 3 bis 5 schematisch dargestellt ist, ermöglicht es, im Verdampfer 60 bei einer Umgebungstemperatur von +30° C eine Temperatur $t_V$ von z.B. -10° C zu erhalten, also einen sehr hohen Temperaturgradienten und folglich einen sehr hohen Wärmestrom selbst bei kleinen Übergangsflächen. Nachfolgend wird dies anhand der Gleichung (1) nochmals erläutert.

Der Kompressor 32 verdichtet das angesaugte Kältemittel 52d bis auf einen Kondensationsdruck $p_K$, und dadurch ergibt sich an seinem Ausgang eine Temperatur $t_2$ (Fig. 5), die deutlich über der jeweiligen Umgebungstemperatur $t_U$ (Fig. 5) liegt. Das verdichtete, überhitzte Kältemittel 52b (Fig. 2) wird über eine Leitung 68 zum Kondensator 44 und durch diesen geführt, damit es dort Wärme abgeben kann und kondensiert.

Der Lüfter 20 bläst oder saugt Luft (mit Umgebungstemperatur $t_U$) durch die Luftseite des Kondensators 44, und diese Luft kühlt den Kondensator 44 und damit auch das überhitzte Kältemittel 52b in diesem. Dabei wird dem Kältemittel 52b so viel Wärme q (vgl. Fig. 4) entzogen, dass es vollständig kondensiert und ggf. noch leicht unterkühlt wird, z.B. um 5 K. Das Kältemittelkondensat ist mit 52c bezeichnet. Es befindet sich noch etwa auf dem hohen Kondensationsdruck $p_K$ (Fig. 4), also dem Punkt 3 der Fig. 3 und 4, wozu eine entsprechend hohe Temperatur $t_K$ von z.B. 45° C gehört. Über die Leitung 64 wird dieses Kondensat 52c einem Drosselventil 62 zugeführt und darin isenthalp, also mit im Wesentlichen gleichbleibender Enthalpie, auf den Verdampfungsdruck $p_V$ entspannt, vgl. den Punkt 4 in Fig. 4. Diesem Verdampfungsdruck $p_V$ ist eine entsprechend niedrige Verdampfertemperatur $t_V$ von z.B. -10° C zugeordnet, wie sie für die Kühlung des Substrats 12 verwendet wird.

Statt eines einzigen Verdampfers 60 können z.B. zwei Verdampfer 60, 60' verwendet werden, die bevorzugt parallel geschaltet sind, aber auch in Serie geschaltet sein können, vgl. Fig. 3.

**Fig. 3** zeigt den Kältekreislauf in schematischer Darstellung als Schaltbild. Da ein Kältemittel 52 verwendet wird, z.B. 1,1,1,2-Tetrafluorethan, Handelsbezeichnung H-FKW134a oder R234a, oder z.B. das Kältemittel R600a, liegt dieses im Kreislauf gemäß Fig. 3 in zwei Phasen vor, nämlich gasförmig und flüssig. In den Verdampfern 60, 60' liegt das Kältemittel 52 als Nassdampf (zusammengesetzt aus siedender Flüssigkeit 52a und Sattdampf, ggf. noch mit leicht überhitztem Dampf) vor. Im Kondensator 44 liegt das Kältemittel als überhitzter Dampf und als Nassdampf sowie als unterkühlte Flüssigkeit vor. Dies sind in Fig. 3 und 4 die Abschnitte zwischen den Punkten, die mit den Ziffern 2 und 3 (Kondensator 44) bzw. 4 und 1 (Verdampfer 60) gekennzeichnet sind. Dabei erhält man zwischen den Punkten 2 und 3 einen Abschnitt mit im Wesentlichen konstantem Druck $p_K$. Damit ist ein erheblich verbesserter Wärmeübergang vom Verdampfer 60, 60' auf das dortige Kältemittel 52a realisierbar, also ein verbessertes $\alpha$, und damit eine erheblich höhere Wärmestromdichte, insbesondere von der Wärmequelle 12 auf den oder die Verdampfer 60, 60' bei unveränderter Temperatur der Wärmequelle 12.

In der Drossel 62 erfolgt eine isenthalpe Zustandsänderung, vgl. im Diagramm der Fig. 4 die vertikale Linie zwischen den Punkten 3 und 4, d.h. es wird keine Energie zu- oder abgeführt, sondern es werden nur Druck und Temperatur des Kältemittels auf das niedrigere Niveau im Verdampfer 60 reduziert. Der Aggregatzustand des unterkühlten Kältemittelkondensats 52c ändert sich dabei ebenfalls von unterkühlter Flüssigkeit (Punkt 3 in Fig. 3 und 4) zu Nassdampf (Punkt 4 in Fig. 3 und 4). Es handelt sich also, wie in Fig. 4 dargestellt, um einen links drehenden Kreisprozess. Der Buchstabe h bezeichnet dort die Enthalpie, gemessen in kJ/kg Kältemittel, und der Buchstabe p bezeichnet den Druck in bar.

In Fig. 4 bezeichnet 70 die Siedelinie, die ein Gebiet 72 reiner Flüssigkeit trennt von einem Nassdampfgebiet 74. Mit 76 ist die Taulinie bezeichnet, die das Gebiet 74 vom Heißdampfgebiet 78 trennt. Mit 80 ist der so genannte kritische Punkt bezeichnet. Im Bereich oberhalb des Punktes 80 ist keine exakte Trennung zwischen Flüssigkeit und Heißdampf mehr möglich. Die zugehörige kritische Temperatur begrenzt folglich den Einsatzbereich des ausgewählten Kältemittels.

Die Temperaturen der Verdampfer 60, 60' können hierbei variiert und auch unter die Umgebungstemperatur abgesenkt werden. Damit ist eine weitere erhebliche Erhöhung der Wärmestromdichte von der Wärmequelle 12 auf einen Verdampfer 60, 60' realisierbar, ohne dass man dazu die Temperatur der Wärmequelle 12 erhöhen muss. Bei Absenkung der Verdampfer-Temperatur $t_V$ unter die TaupunktTemperatur der umgebenden Luft ist eine Kälteisolation 86 der kalten Bauelemente zweckmäßig, also wie dargestellt des Drosselventils 62, des Verdampfers 60 und der Verbindungsleitung 66 bis zum Kompressor 32. Hierdurch wird vermieden, dass Wasser aus der Umgebungsluft an den kalten Bauelementen auskondensiert, was zu Schwierigkeiten an elektrischen Bauteilen führen könnte.

Das Kältemittel 52a, 52d liegt im Verdampfer 60 bei im Wesentlichen gleich bleibender Temperatur vor, d.h. bei der Wärmeübertragung tritt kein wesentlicher Temperaturgradient des Kältemittels 52 selbst auf, von einer geringen Überhitzung im Verdampfer 60 abgesehen (z.B. um 5 K), weil hier fast ausschließlich latente Wärme (Phasenumwandlung) übertragen wird. Damit ist eine weitgehend gleichmäßige und niedrige Temperatur der Verdampfer 60, 60' gewährleistet, wie sie für eine zuverlässige Kühlung von Halbleiter-Substraten angestrebt wird. Dazu trägt auch bei, dass gemäß der Darstellung in Fig. 1 und 6 die Wärmeübertragungsflächen der Verdampfer 60 bzw. 100 hauptsächlich mit siedender Flüssigkeit 52a bedeckt sind.

**Fig. 5** zeigt den Verlauf der Temperatur über dem Weg L im Kältekreislauf. Der Weg L ist in Fig. 3 symbolisch eingezeichnet und so zu denken, dass ein Beobachter mit dem Kältemittel mitwandert und am Ende wieder an seinen Ausgangspunkt zurück gelangt. Es handelt sich hier um eine Darstellungsart, die für solche Systeme gebräuchlich ist. Die Punkte 1, 2, 3 und 4 sind dieselben, wie sie in den vorhergehenden Figuren angegeben sind.

Am Punkt 4, nämlich dem Eintritt in den Verdampfer 60, 60', hat das Kältemittel seine niedrigste Temperatur $t_V$ (Verdampfertemperatur), z.B. -10 °C, d. h. es liegt hauptsächlich als Nassdampf vor, was für die Wärmeübertragung sehr günstig ist. Unter Nassdampf versteht man ein Gemisch aus siedender Flüssigkeit und gesättigten Dampf. Ein anschauliches Bild für Nassdampf ist ein Kochtopf mit siedendem Wasser bei normalem Luftdruck. Das siedende Wasser behält seine Temperatur von 100 °C bei, bis es komplett verdampft ist. Vgl. hierzu Fig. 5: In gleicher Weise behält hier das Kältemittel in einem Bereich 78 bis zum Erreichen einer Stelle 80, nämlich seiner Taulinie, diese Temperatur $t_v$ von z. B. -10 °C bei, und im Bereich 82 zwischen der Stelle 80 und der Stelle 1 kann eine geringfügige Überhitzung des Nassdampfes stattfinden, z. B. um 5 K, wodurch die Temperatur des Kältemittels in diesem Bereich 82 etwas ansteigen kann. Da das Kältemittel hier im Wesentlichen als Nassdampf vorliegt, ist der Wärmedurchgangskoeffizient k erhöht, vgl. die nachfolgende Gleichung (1) und die Erläuterungen hierzu.

Zwischen den Punkten 1 und 2 ist der Kompressor 32 wirksam, der an der Stelle 2 einen entsprechenden Anstieg von Druck und Temperatur bewirkt, welch letztere am Ausgang des Kompressors 32 ihr Maximum $t_2$ erreicht. Dort liegt das Kältemittel als verdichteter überhitzter Dampf vor.

Zwischen den Stellen 2 und 3 strömt das Kältemittel durch den Kondensator 44. Dort wird es gekühlt, so dass seine Temperatur zunächst zwischen der Stelle 2 und einer Stelle 84, nämlich dem Erreichen der Taulinie, in einem Bereich 86 auf die Kondensationstemperatur $t_K$ sinkt. Durch die fortgesetzte Wärmeabfuhr infolge der Kühlung im Kondensator 44 erfolgt zwischen den Stellen 84 und 90 eine vollständige Kondensation des Kältemittels bis zum Erreichen der Siedelinie 90, wobei dem Kältemittel eine entsprechende Wärmemenge q (Fig. 4) entzogen wird. Zwischen den Punkten 90 und 3 kann in einem Bereich 92 auch eine leichte Unterkühlung des Kältemittels stattfinden, z.B. um 5 K.

Es ist darauf hinzuweisen, dass die Kondensationstemperatur $t_K$ deutlich, z. B. um 10 K, über der Umgebungstemperatur $t_U$ liegt, was den Wärmeübergang vom Kondensator 44 auf die Umgebungsluft entsprechend verbessert, vgl. Fig. 5.

Zwischen den Stellen 3 und 4 durchströmt das kondensierte Kältemittel die Drossel 62, und an ihrem Ausgang ist seine Temperatur wieder auf die Verdampfertemperatur $t_v$ gesunken, die z. B. -10 °C betragen kann und die in den Verdampfern 60, 60' aus den erläuterten Gründen im Bereich 78 praktisch konstant bleibt, wobei allenfalls im Bereich 82 durch Überhitzung ein kleiner Temperaturanstieg um 5 K erfolgen kann. Dies ermöglicht einen exzellenten Wärmeübergang vom Prozessor 12 auf das Kältemittel 52, da am Prozessor 12 ein hoher und im Wesentlichen konstanter Temperaturgradient vorliegt, so dass die Kühlung überall gleich gut ist. Wenn der Prozessor 12 z. B. eine Temperatur von +60 °C und das Kältemittel eine Verdampfertemperatur $t_v$ von -10 °C hat, ergibt sich ein im wesentlichen konstanter Temperaturgradient von 70 K, der eine exzellente Kühlung auch in einem kleinen Volumen ermöglicht.

Sehr vorteilhaft ist, dass eine niedrige Temperatur praktisch nur zwischen den Stellen 4 und 1 des Kältekreislaufes vorliegt, d. h. eine Wärmeisolation 86 ist nur in diesem Bereich erforderlich, nicht aber am Kondensator 44 oder am Kompressor 32. Dies ist eine Folge davon, dass der Kondensator 44 bei einer Kondensationstemperatur $t_K$ arbeitet, die z.B. +45 °C oder höher beträgt. Selbst bei einer geringfügigen Unterkühlung um 5 K im Bereich 92 kann dort die Temperatur immer noch auf +40 °C gehalten werden, also über der Taupunkttemperatur der umgebenden Luft, so dass dort ein Auskondensieren von Feuchtigkeit aus der Luft nicht auftreten kann. Gerade in Anordnungen zur Kühlung von elektronischen Bauelementen erscheint dies als sehr wichtig, weil dort auskondensierte Feuchtigkeit zu Fehlfunktionen führen könnte.

Mathematisch ausgedrückt berechnet sich der zu übertragende Wärmestrom als

$$dQ/dt = k*A*\Delta\vartheta m \qquad\qquad ...(1)$$

Dabei bedeuten:

dQ/dt = Wärmestrom in W
k = Wärmedurchgangskoeffizient in W/m$^2$K;
A = Wärmeübertragungsfläche in m$^2$ ;
$\Delta\vartheta$m = mittlere logarithmische Temperaturdifferenz der Wärmeübertragung.

Bei der Erfindung hat die Wärmeübertragungsfläche A einen fixen Wert. Eine deutliche Erhöhung des Wärmestroms dQ/dt ergibt sich bei der Erfindung durch folgende Faktoren:

a) Der Wärmedurchgangskoeffizient k ist deutlich erhöht, weil die Wärme im Wesentlichen im Nassdampfbereich übertragen wird.
b) Die mittlere logarithmische Temperaturdifferenz $\Delta\vartheta$m wird deutlich erhöht, weil die Verdampfertemperatur bis weit unter die Umgebungstemperatur abgesenkt werden kann, selbst bei feststehender Temperatur des Substrats 12 bzw. 106 (Fig. 6).

**Fig. 6** zeigt einen Schnitt durch einen vorteilhaften Verdampfer 100. Dieser kann, bedingt durch seine Bauweise, im Wesentlichen lageunabhängig betrieben werden. Er arbeitet nach dem Prinzip einer Prallplatte, um eine hohe Wärmestromdichte zu erreichen.

Der Verdampfer 100 hat ein Oberteil 102, das gewöhnlich einstückig und als Spritzgussteil aus einem geeigneten Kunststoff hergestellt ist, und er hat eine Kälteplatte 104 aus einem geeigneten Metall, meistens Kupfer, die zur Anlage gegen ein wärmeerzeugendes Substrat 106 ausgebildet ist, das in einem Träger 108 (für die elektrischen Verbindungen des Substrats 106) angeordnet ist. Die Kälteplatte 104 kann z. B. als Fließpress-Teil aus Kupfer, Aluminium, Silber oder dgl. hergestellt werden. Dies ermöglicht es, die Kälteplatte 104 einfach und preiswert herzustellen, während das Oberteil einen komplizierten Aufbau haben kann und trotzdem leicht herzustellen ist.

Die Kälteplatte 104 hat eine Wärme übertragende Fläche 110, welche eine hohe Oberflächengüte hat und vollflächig gegen das Substrat 106 anliegt, wobei gewöhnlich etwas Wärmeleitpaste 111 zwischen die Fläche 110 und das Substrat 106 eingefügt wird. Die Wärmezufuhr dq/dt vom Substrat 106 ist symbolisch durch Pfeile dargestellt, um den Wärmestrom zu verdeutlichen.

Das Oberteil 102 hat in seiner Mitte eine Zufuhrleitung 112, an deren unterem Ende sich bevorzugt Düsen 114 befinden. Durch die Zufuhrleitung 112 wird entspanntes Kältemittel 52 als Nassdampf zugeführt und durch die Düsen 114 auf die Kälteplatte 104 gespritzt. Hierdurch findet eine Erhöhung der Turbulenz und eine zusätzliche Verbesserung des Wärmeübergangs von der Kälteplatte 104 auf das Kältemittel 52 statt. Die Düsen 114 können z.B. Lochdüsen oder Schlitzdüsen sein.

Die Kälteplatte 104 hat eine muldenförmige Vertiefung 114, z. B. mit der Umrissform einer Kugelkalotte, eines Rotations-Paraboloids, einer Schale, oder dgl. Aus dieser Vertiefung 114 ragen nadelförmige Kühlkörper 116 nach oben bis zu einer Ebene 118, die parallel zur Fläche 110 verläuft, wie Fig. 6 klar zeigt. Die Kühlkörper 116 können je nach Bedarf auch als Rippen oder dgl. ausgebildet werden, wie das dem Fachmann bekannt ist, und ihre Höhe kann variiert werden.

Zwischen den nadelförmigen Kühlkörpern 116 befinden sich Kühlkanäle 120, und in diese wird der Nassdampf 52 nach Art einer Prallströmung gespritzt, so dass sich ein guter Wärmeübergang ergibt. Durch die Prallströmung kann auf engstem Raum eine sehr hohe Wärmestromdichte erreicht werden, die durch die niedrige Kältemitteltemperatur noch weiter erhöht wird. Durch die Düsen 114 ist eine Strahleinschnürung (Coanda-Effekt) möglich, die ebenfalls zur Verbesserung der Wärmeübertragung beiträgt.

Wie man sieht, spielt es beim Verdampfer 100 gemäß Fig. 6 keine Rolle, ob dieser exakt waagerecht steht oder eine leichte Schräglage hat, da sich hierdurch an der Wärmeübertragung von der Kälteplatte 104 auf den Nassdampf 52 nichts Wesentliches ändert. Dies stellt einen großen Vorteil der Anordnung nach Fig. 6 dar, da in der Praxis nicht erwartet werden kann, dass z.B. ein Rechner, dessen Bestandteil der Mikroprozessor 106 ist, vollständig waagerecht aufgestellt wird.

Etwa konzentrisch zur Zufuhrleitung 112 ist auf der Unterseite 122 des Oberteils 102 eine ringförmige Blende 124 angeordnet, die nach unten ragt und bevorzugt gegen die oberen Enden der dortigen Kühlkörper 116 anliegt oder sogar etwas in die Kanäle 120 ragt. Dadurch wird der Nassdampf 52 gezwungen, vom Zentrum durch die Kanäle 120 in alle Richtungen radial nach außen zu strömen, was die Wärmeübertragung zusätzlich verbessert. Ohne die Blende 124 würde der Nassdampf 52 hauptsächlich direkt vom Einlass 112 zu einem Auslasskanal 126 strömen, und nicht zwischen den Kühlkörpern 116 hindurch.

Der Auslasskanal 126 ist im Oberteil 102 vorgesehen. Seine Mittelachse 128 verläuft etwa so, dass sie durch den äußeren Rand 130 der (bevorzugt kreisrunden) Kälteplatte 104 verläuft.

Das Oberteil 102 hat einen Fortsatz 132, der sich etwa rohrförmig, und etwa konzentrisch zum Einlass 112, nach unten erstreckt, und in diesem Fortsatz 132 ist die Kälteplatte 104 abgedichtet befestigt, z. B. mittels einer umlaufenden Dichtung 134 oder mittels Kleben, Schweißen, Löten oder dgl.

Wenn der Nassdampf 52 durch die Kanäle 120 zwischen den Kühlkörpern 116 strömt, verdampft er, so dass durch den Auslass 126 Sattdampf 52 oder überhitzter Dampf austritt. Gewöhnlich wird ein Trockner 138 nachgeschaltet, um mitgerissene Flüssigkeitsteilchen abzuscheiden, da diese den Kompressor 32 beschädigen könnten.

Der Verdampfer 100 hat auch eine integrierte umlaufende Montageplatte 140, mit der er auf einem Substrat 106 befestigt werden kann. Für die Befestigung können bekannte Befestigungsarten verwendet werden.

Naturgemäß sind im Rahmen der vorliegenden Erfindung vielfache Abwandlungen und Modifikationen möglich.

**Patentansprüche**

1. Verfahren zur Kühlung eines Substrats nach Art einer Halbleiteranordnung mittels eines Kältemittels, welches Verfahren folgende Schritte aufweist:

In einem Kältekreislauf wird das Kältemittel in einem Verdichter verdichtet;
das verdichtete Kältemittel wird in einem Kondensator durch Kühlung mittels eines Ventilators kondensiert;
das kondensierte Kältemittel wird einem Entspannungsschritt unterworfen, um seinen Druck und seine Temperatur zu reduzieren, so dass es nach der Entspannung als siedende Flüssigkeit und als Nassdampf vorliegt; siedende Flüssigkeit und Nassdampf werden einem Verdampfer zugeführt, der mit dem zu kühlenden Substrat in Wärmeverbindung steht;

verdampftes Kältemittel aus dem Verdampfer wird erneut dem Schritt der Verdichtung unterworfen, Verdichter und Lüfter werden mittels eines gemeinsamen Antriebsmotors angetrieben; und die Verdampfertemperatur ($t_v$) wird durch Änderung der Drehzahl dieses gemeinsamen Antriebsmotors (42) geregelt.

2. Verfahren nach Anspruch 1, bei welchem das kondensierte Kältemittel beim Entspannungsschritt isenthalp entspannt wird.

3. Verfahren nach Anspruch 1 oder 2, bei welchem das Kältemittel bei seiner Verdichtung auf eine Temperatur ($t_2$) erhitzt wird, die höher ist als die Temperatur eines zu seiner Kühlung dienenden Kühlmittels.

4. Verfahren nach Anspruch 3, bei welchem als Kühlmittel Umgebungsluft verwendet wird, und das Kältemittel bei seiner Verdichtung auf eine Temperatur ($t_2$) erwärmt wird, die höher ist als die Temperatur ($t_u$) dieser Umgebungsluft.

5. Kühlanordnung zur Kühlung eines Substrats nach Art einer Halbleiteranordnung, welche Kühlanordnung als Kaltdampf-Kältemaschine ausgebildet ist, in deren Kältekreislauf ein Kältemittelverdichter (32), ein Kondensator (44) zur Wärmeabgabe an die Umgebungsluft, und ein Verdampfer (60) angeordnet sind, wobei

• dem Verdampfer (60) ein Drosselventil (62) zur Entspannung des Kältemittels vorgeschaltet ist,
• der Verdampfer (60) als Wärmeaufnehmer zur Aufnahme von Wärme aus dem Substrat (20) ausgebildet ist,
• beide Aggregate, nämlich der Kältemittelverdichter (32) und der dem Kondensator (44) zugeordnete Lüfter (20), vom selben Antriebsmotor (42) antreibbar sind,
• und ein Regler (54) vorgesehen ist, welcher die Verdampfertemperatur ($t_v$) durch Änderung der Drehzahl dieses Antriebsmotors (42) regelt.

6. Kühlanordnung nach Anspruch 5, bei welcher der Antriebsmotor (42) eines der beiden Aggregate (20, 32) direkt und das andere über eine Magnetkupplung (34) antreibt.

7. Kühlanordnung nach Anspruch 5 oder 6, bei welcher der Kondensator (44) mit dem ihm zugeordneten Lüfter (20) und dem Antriebsmotor (42) zu einer Baueinheit vereinigt ist.

8. Kühlanordnung nach einem der Ansprüche 5 bis 7, bei welcher der Kreisprozess der Kaftdampf-Kältemaschine ein linksdrehender Kreisprozess ist.

9. Kühlanordnung nach einem der Ansprüche 5 bis 8, bei welcher das Kältemittel im Kreislauf in zwei Phasen vorliegt, nämlich gasförmig und flüssig.

10. Kühlanordnung nach einem der Ansprüche 5 bis 9, bei welcher im Betrieb das Kältemittel im Verdampfer (60; 60') im Wesentlichen in Form einer siedenden Flüssigkeit (52a) und von gesättigtem Kältemitteldampf (52d) vorliegt.

11. Kühlanordnung nach einem der Ansprüche 5 bis 10, bei welcher das Lüftergehäuse (22) und das Kompressorgehäuse (36) mindestens teilweise zu einer Baueinheit (40) vereinigt sind.

12. Kühlanordnung nach Anspruch 11, bei welcher die Baueinheit mindestens teilweise als Spritzgussteil (40) ausgebildet ist.

13. Kühlanordnung nach Anspruch 12, bei welcher das Spritzgussteil (40) mindestens teilweise aus einem geeigneten Kunststoff hergestellt ist.

14. Kühlanordnung nach einem der Ansprüche 5-13, bei welcher der Verdampfer (100) nach dem Prinzip einer Prallplatte ausgebildet ist.

15. Kühlanordnung nach Anspruch 14, bei welcher an der Eintrittsstelle des Kältemittels (52) in den Verdampfer (100) eine Düsenanordnung (114) vorgesehen ist.

16. Kühlanordnung nach Anspruch 15, bei welcher die Düsenanordnung (114) eine Lochdüse aufweist.

**17.** Kühlanordnung nach Anspruch 15, bei welcher die Düsenanordnung (114) eine Schlitzdüse aufweist.

**18.** Kühlanordnung nach einem der Ansprüche 15 bis 17, bei weicher die Düsenanordnung zur Erzeugung einer Strahleinschnürung ausgebildet ist.

**19.** Kühlanordnung nach einem der Ansprüche 5-18, bei welcher die wärmeübertragende Fläche (114) im Verdampfer (100) auf ihrer vom Wärme abgebenden Substrat (106) abgewandten Seite konkav ausgebildet ist.

**20.** Kühlanordnung nach Anspruch 19, bei welcher die konkave Fläche (114) etwa nach Art einer Kugelkalotte ausgebildet ist.

**21.** Kühlanordnung nach Anspruch 19, bei welcher die konkave Fläche (114) etwa nach Art eines Rotations-Paraboloids ausgebildet ist.

**22.** Kühlanordnung nach einem der Ansprüche 19 bis 21, bei welcher auf der konkaven Fläche (114) Wärmetauschelemente (116) mit Abständen (120) voneinander angeordnet sind.

**23.** Kühlanordnung nach Anspruch 22, bei welcher die Wärmetauschelemente mindestens teilweise nach Art von Nadeln (116) ausgebildet sind.

**24.** Kühlanordnung nach Anspruch 22 oder 23, bei welcher im Bereich um die Eintrittsstelle (114) des Kältemittels (52) in den Verdampfer (100) mindestens eine Sperre (124) vorgesehen ist, welche als Hindernis gegen eine direkte Strömung des Kältemittels (52) vom Einlass (112) zum Auslass (126) wirksam ist.

**25.** Kühlanordnung nach einem der Ansprüche 19 bis 24, bei welcher der Teil (104) des Verdampfers (100), an welchem die konkave Fläche (114) vorgesehen ist, als Fließpressteil aus einem wärmeleitenden Werkstoff nach Art von Kupfer, Aluminium oder Silber ausgebildet ist.

**26.** Kühlanordnung nach einem der Ansprüche 5 bis 25, bei welcher der Verdampfers (100) eine Baugruppe (102) aufweist, an der Kältemitteleinlass (112) und Kältemittelauslass (126) vorgesehen sind.

**27.** Kühlanordnung nach Anspruch 26, bei welcher die Baugruppe (102) als Formstück aus Kunststoff ausgebildet ist.

**28.** Kühlanordnung nach einem der Ansprüche 5 bis 27, bei welcher der Verdampfer (100) aus mindestens zwei Teilen (102, 104) zusammengesetzt ist, welche flüssigkeitsdicht miteinander verbunden sind.

**29.** Kühlanordnung nach Anspruch 28, bei welcher eine Anordnung (140) zur Befestigung des Verdampfers (100) in mindestens einem dieser Teile (102, 104) integriert ist.

**30.** Kühlanordnung nach Anspruch 28 oder 29, bei welcher die Teile (102, 104) mittels einer Radialdichtung (134) gegeneinander abgedichtet sind.

**Claims**

**1.** Method for cooling a substrate such as a semiconductor arrangement by means of a refrigerant, which method comprises the following steps:

in a refrigerant circuit the refrigerant is compressed in a compressor;
the compressed refrigerant is condensed in a condenser by cooling by means of a fan;
the condensed refrigerant is subjected to a relieving step in order to reduce its pressure and its temperature so that it is present after the relieving step as a boiling liquid and as wet vapour;
the boiling liquid and wet vapour are fed to an evaporator which is in thermal connection with the substrate to be cooled;
evaporated refrigerant from the evaporator is subjected to the compression step again;
the compressor and fan are driven by means of a common driving motor;
and the evaporator temperature ($t_v$) is regulated by changing the rotational speed of this common driving motor (42).

**2.** Method according to claim 1, in which the condensed refrigerant is relieved isenthalpically in the relieving step.

**3.** Method according to claim 1 or 2, in which the refrigerant is heated during its compression to a temperature ($t_2$) which is higher than the temperature of a coolant serving for its cooling.

**4.** Method according to claim 3, in which ambient air is used as the coolant, and the refrigerant is heated during its compression to a temperature ($t_2$) which is higher than the temperature ($t_u$) of this ambient air.

**5.** Cooling arrangement for cooling a substrate such as a semiconductor arrangement, which cooling arrangement is embodied as a cold vapour refrigerating machine the refrigerant circuit of which comprises a refrigerant compressor (32), a condenser (44) for giving off heat to the ambient air, and an evaporator (60), wherein

- the evaporator (60) is preceded by a regulating valve (62) for relieving the refrigerant;
- the evaporator (60) is embodied as a heat absorber for absorbing heat from the substrate (20);
- the two units, namely the refrigerant compressor (32) and the fan (20) associated with the condenser (44), can be driven by the same driving motor (42);
- and a controller (54) is provided which controls the evaporator temperature ($t_v$) by changing the rotational speed of this driving motor (42).

**6.** Cooling arrangement according to claim 5, in which the driving motor (42) drives one of the two units (20, 32) directly and the other through a magnetic coupling (34).

**7.** Cooling arrangement according to claim 5 or 6, in which the condenser (44) is combined with the fan (20) associated with it and the driving motor (42) to form a unit.

**8.** Cooling arrangement according to one of claims 5 to 7, in which the cyclic process of the cold vapour refrigerating machine is a counter clockwise cyclic process.

**9.** Cooling arrangement according to one of claims 5 to 8, in which the refrigerant in the circuit is present in two phases, namely gaseous and liquid.

**10.** Cooling arrangement according to one of claims 5 to 9, in which while in operation the refrigerant in the evaporator (60; 60') is essentially present in the form of a boiling liquid (52a) and saturated refrigerant vapour (52d).

**11.** Cooling arrangement according to one of claims 5 to 10, in which the fan housing (22) and the compressor housing (36) are at least partly combined to form a unit (40).

**12.** Cooling arrangement according to claim 11, in which the unit is at least partly embodied as an injection moulding (40).

**13.** Cooling arrangement according to claim 12, in which the injection moulding (40) is at least partly manufactured from a suitable plastic.

**14.** Cooling arrangement according to one of claims 5 to 13, in which the evaporator (100) is embodied according to the principle of a baffle plate.

**15.** Cooling arrangement according to claim to 14, in which a nozzle arrangement (114) is provided at the point at which the refrigerant (52) enters the evaporator (100).

**16.** Cooling arrangement according to claim 15, in which the nozzle arrangement (114) comprises a hole-type nozzle.

**17.** Cooling arrangement according to claim 15, in which the nozzle arrangement (114) comprises a slit-type nozzle.

**18.** Cooling arrangement according to one of claims 15 to 17, in which the nozzle arrangement is designed to produce a Coanda effect.

**19.** Cooling arrangement according to one of claims 5 to 18, in which the heat-transferring surface (114) in the evaporator (100) is concave in form on its side remote from the substrate (106) giving off heat.

20. Cooling arrangement according to claim 19, in which the concave surface (114) is embodied roughly like a spherical cap.

21. Cooling arrangement according claim 19, in which the concave surface (114) is embodied roughly like a rotation paraboloid.

22. Cooling arrangement according to one of claims 19 to 21, in which heat exchanging elements (116) are arranged with gaps (120) between one another on the concave surface (114).

23. Cooling arrangement according to claim 22, in which the heat exchanging elements are at least partly embodied like needles (116).

24. Cooling arrangement according to claim 22 or 23, in which at least one barrier (124) is provided in the area around the point (114) at which the refrigerant (52) enters the evaporator (100), which barrier acts as an obstruction to prevent the refrigerant (52) flowing directly from the inlet (112) to the outlet (126).

25. Cooling arrangement according to one of claims 19 to 24, in which the part (104) of the evaporator (100) on which the concave surface (114) is provided is embodied as an extrusion made of a heat-conducting material such as copper, aluminium or silver.

26. Cooling arrangement according to one of claims 5 to 25, in which the evaporator (100) comprises an assembly (102) on which the refrigerant inlet (112) and refrigerant outlet (126) are provided.

27. Cooling arrangement according to claim 26, in which the assembly (102) is embodied as a moulding made of plastic.

28. Cooling arrangement according to one of claims 5 to 27, in which the evaporator (100) is composed of at least two parts (102, 104) which are connected to one another in a liquid-tight manner.

29. Cooling arrangement according to claim 28, in which an arrangement (140) for fastening the evaporator (100) is integrated in at least one of these parts (102, 104).

30. Cooling arrangement according to claim 28 or 29, in which the parts (102, 104) are sealed in relation to one another by means of a radial seal (134).

**Revendications**

1. Procédé pour refroidir un substrat à la manière d'un dispositif à semi-conducteur au moyen d'un fluide réfrigérant, lequel procédé comprend les étapes suivantes :

dans un circuit frigorifique, le fluide réfrigérant est comprimé dans un compresseur ;
le fluide réfrigérant comprimé est condensé dans un condenseur par refroidissement au moyen d'un ventilateur ;
le fluide réfrigérant condensé est soumis à une étape de détente pour réduire sa pression et sa température de manière à être disponible sous forme de liquide en ébullition et sous forme de vapeur humide après la détente ;
liquide en ébullition et vapeur humide sont amenés à un évaporateur qui est en liaison thermique avec le substrat à refroidir ;
le fluide réfrigérant vaporisé provenant de l'évaporateur est à nouveau soumis à l'étape de compression,
compresseur et ventilateur sont entraînés au moyen d'un moteur d'entraînement commun et la température de l'évaporateur ($t_v$) est régulée par modification de la vitesse de rotation de ce moteur d'entraînement (42) commun.

2. Procédé selon la revendication 1, dans lequel le fluide réfrigérant condensé est détendu de manière isenthalpique lors de l'étape de détente.

3. Procédé selon la revendication 1 ou 2, dans lequel le fluide réfrigérant est chauffé lors de sa compression à une température ($t_2$) qui est plus élevée que la température d'un fluide de refroidissement utilisé pour son refroidissement.

4. Procédé selon la revendication 3, dans lequel on utilise l'air ambiant comme fluide de refroidissement et le fluide réfrigérant est réchauffé lors de sa compression à une température ($t_2$) qui est plus élevée que la température ($t_u$)

de cet air ambiant.

5. Dispositif de refroidissement pour refroidir un substrat à la manière d'un dispositif à semi-conducteur, lequel dispositif de refroidissement est réalisé sous forme de machine frigorifique à vapeur froide dont le circuit frigorifique comprend un compresseur de fluide réfrigérant (32), un condenseur (44) pour la dissipation de chaleur dans l'air ambiant et un évaporateur (60), sachant que

   ■ une vanne d'étranglement (62) pour la détente du fluide réfrigérant est placée avant l'évaporateur (60),
   ■ l'évaporateur (60) est réalisé sous forme d'absorbeur de chaleur pour absorber la chaleur du substrat (20),
   ■ les deux agrégats, à savoir le compresseur de fluide réfrigérant (32) et le ventilateur (20) associé au condenseur (44) peuvent être entraînés par le même moteur d'entraînement (42),
   ■ et il est prévu un régulateur (54) qui régule la température de l'évaporateur ($t_v$) par modification de la vitesse de rotation de ce moteur d'entraînement (42).

6. Dispositif de refroidissement selon la revendication 5, dans lequel le moteur d'entraînement (42) entraîne un des deux agrégats (20, 32) directement et l'autre par l'intermédiaire d'un embrayage magnétique (34).

7. Dispositif de refroidissement selon la revendication 5 ou 6, dans lequel le condenseur (44) est réuni en une unité modulaire avec le ventilateur (20) qui lui est associé et le moteur d'entraînement (42).

8. Dispositif de refroidissement selon l'une des revendications 5 à 7, dans lequel le cycle de la machine frigorifique à vapeur froide est un cycle tournant à gauche.

9. Dispositif de refroidissement selon l'une des revendications 5 à 8, dans lequel le fluide réfrigérant existe dans le circuit sous deux phases, à savoir gazeuse et liquide.

10. Dispositif de refroidissement selon l'une des revendications 5 à 9, dans lequel, en fonctionnement, le fluide réfrigérant présent dans l'évaporateur (60 ; 60') existe essentiellement sous forme d'un liquide en ébullition (52a) et de vapeur de fluide réfrigérant saturée (52d).

11. Dispositif de refroidissement selon l'une des revendications 5 à 10, dans lequel le boîtier de ventilateur (22) et le boîtier de compresseur (36) sont réunis au moins partiellement en une unité modulaire (40).

12. Dispositif de refroidissement selon la revendication 11, dans lequel l'unité modulaire est réalisée au moins partiellement sous forme de pièce moulée par injection (40).

13. Dispositif de refroidissement selon la revendication 12, dans lequel la pièce moulée par injection (40) est réalisée au moins partiellement dans une matière plastique appropriée.

14. Dispositif de refroidissement selon l'une des revendications 5 à 13, dans lequel l'évaporateur (100) est réalisé selon le principe d'une plaque déflectrice.

15. Dispositif de refroidissement selon la revendication 14, dans lequel il est prévu un dispositif de buse (114) au point d'entrée du fluide réfrigérant (52) dans l'évaporateur (100).

16. Dispositif de refroidissement selon la revendication 15, dans lequel le dispositif de buse (114) présente une buse à trou.

17. Dispositif de refroidissement selon la revendication 15, dans lequel le dispositif de buse (114) présente une buse à fente.

18. Dispositif de refroidissement selon l'une des revendications 15 à 17, dans lequel le dispositif de buse est conçu pour générer un rétrécissement de jet.

19. Dispositif de refroidissement selon l'une des revendications 5 à 18, dans lequel la surface de transfert de chaleur (114) de l'évaporateur (100) présente une forme concave sur son côté éloigné du substrat (106) cédant de la chaleur.

20. Dispositif de refroidissement selon la revendication 19, dans lequel la surface concave (114) est à peu près formée à la manière d'une calotte sphérique.

21. Dispositif de refroidissement selon la revendication 19, dans lequel la surface concave (114) est à peu près formée à la manière d'un paraboloïde de révolution.

22. Dispositif de refroidissement selon l'une des revendications 19 à 21, dans lequel des éléments échangeurs de chaleur (116) sont disposés à intervalles (120) les uns des autres sur la surface concave (114).

23. Dispositif de refroidissement selon la revendication 22, dans lequel les éléments échangeurs de chaleur sont réalisés au moins partiellement à la manière d'aiguilles (116).

24. Dispositif de refroidissement selon la revendication 22 ou 23, dans lequel il est prévu dans la zone autour du point d'entrée (114) du fluide réfrigérant (52) dans l'évaporateur (100) au moins un élément de blocage (124) qui agit comme obstacle à un passage direct du fluide réfrigérant (52) de l'entrée (112) vers la sortie (126).

25. Dispositif de refroidissement selon l'une des revendications 19 à 24, dans lequel la partie (104) de l'évaporateur (100) sur laquelle la surface concave (114) est prévue est réalisée sous forme de pièce extrudée en matériau thermoconducteur du genre cuivre, aluminium ou argent.

26. Dispositif de refroidissement selon l'une des revendications 5 à 25, dans lequel l'évaporateur (100) présente un sous-groupe (102) sur lequel l'entrée de fluide réfrigérant (112) et la sortie de fluide réfrigérant (126) sont prévues.

27. Dispositif de refroidissement selon la revendication 26, dans lequel le sous-groupe (102) est réalisé sous forme de pièce moulée en matière plastique.

28. Dispositif de refroidissement selon l'une des revendications 5 à 27, dans lequel l'évaporateur (100) est composé d'au moins deux parties (102, 104) qui sont reliées ensemble de manière étanche aux liquides.

29. Dispositif de refroidissement selon la revendication 28, dans lequel un dispositif (140) de fixation de l'évaporateur (100) est intégré dans au moins une de ces parties (102, 104).

30. Dispositif de refroidissement selon la revendication 28 ou 29, dans lequel les parties (102, 104) sont rendues étanches l'une par rapport à l'autre au moyen d'un joint radial (134).

Fig. 1

EP 1 611 778 B1

Fig. 2

Fig. 3

Fig. 4

Fig. 5

Fig. 6